# EUROPEAN PATENT SPECIFICATION

(11) **EP 3 783 665 B1**
(45) Date of publication and mention of the grant of the patent: **02.12.2026**
(21) Application number: 19193018.9
(22) Date of filing: 22.08.2019
(51) Int. Cl.: H10D 30/66, H10D 62/13, H10D 62/10

(54) **SUPERJUNCTION TRANSISTOR DEVICE WITH SOFT SWITCHING BEHAVIOR**
SUPERJUNTION-TRANSISTORVORRICHTUNG MIT SANFTEM SCHALTVERHALTEN
DISPOSITIF DE TRANSISTOR À SUPERJONCTION AYANT UN COMPORTEMENT DE COMMUTATION SOUPLE

(43) Date of publication of application: 24.02.2021
(73) Proprietor: Infineon Technologies Austria AG, 9500 Villach (AT)
(72) Inventor: WEBER, Hans, 83457 München (DE); FISCHER, Björn, 81547 München (DE); HIRLER, Franz, 84424 Isen (DE); KUTSCHAK, Matteo-Alessandro, 9072 Ludmannsdorf (AT); RIEGLER, Andreas, 9241 Lichtpold (AT)
(74) Representative: Westphal, Mussgnug & Partner, Patentanwälte mbB

(56) References cited:
- US-A1- 2008 035 992
- US-A1- 2009 250 727
- US-A1- 2016 118 492
- US-A1- 2017 125 515

## Description

This disclosure relates in general to a transistor device, in particular a superjunction transistor device.

A superjunction transistor device usually includes a drain region, plurality of drift regions of a first doping type, a plurality of compensation regions of a second doping type adjoining the drift regions, and a plurality of transistor cells. Each of the transistor cells includes a body region adjoining one of the drift regions, a source region adjoining the body region, and a gate electrode adjacent the body region and dielectrically insulated from the body region by a gate dielectric.

Superjunction transistor devices can be operated in an on-state and an off-state. In the on-state, a drive voltage (gate-source voltage) is applied between the gate electrode and the source region of each transistor cell such that there is a conducting channel in the body region between the source region and the drift region. In the on-state, a load current can flow between the drain region and the source regions when a voltage is applied between the drain region and the source regions. In the off-state, the gate electrodes of the transistor cells are driven such that the conducting channels in the body regions are interrupted, so that the load current is zero.

Superjunction transistor devices are capable of rapidly changing the switching state from the on-state to the off-state, or vice versa. Thus, switching on or switching off the transistor device may be associated with high gradients (transients, slopes) of the load current. High load current gradients, however, may cause voltage spikes of voltages across resonant circuits or any kind of non-parasitic or parasitic inductances, such as line inductances of connection lines between the transistor device and a load and/or a power source. Such voltage spikes may damage electronic devices in the same circuit as the transistor device or may cause high voltages a gate node of the transistor device, wherein such high voltages (which are sometimes referred to as gate ringing) may damage the transistor device.

US 2016/0118492 A1 discloses a superjunction transistor device that includes source regions, body regions, a drift region and compensation regions, wherein the compensation regions adjoin the drift region. The compensation regions are separated from the body regions by insulating trenches and are connected to a source electrode.

US 2017/0125515 A1 discloses a superjunction transistor device that includes source regions, body regions, drift regions and compensation regions. The compensation regions adjoin the drift regions and are separated from the body regions by insulating trenches. The source regions, the body regions and the compensation regions are connected to a source electrode.

US 2008/0035992 A1 discloses a transistor device with source regions, body regions and a drift region. The source and body regions are arranged between trench gate electrodes. The source regions and body regions are connected to a source electrode, wherein in a direction that is perpendicular to a direction in which the trench gate electrodes are spaced apart from each other source regions and body region contact regions are arranged alternatingly.

US 2009/0250727 A1 discloses a superjunction transistor device that includes source regions, body regions, compensation regions and a drift region. The compensation regions extend in a vertical direction of a semiconductor body and adjoin the drift region at a respective vertical lower end. In directions perpendicular to the vertical direction the compensation regions are separated from the drift region by silicon dioxide layers.

There is a need for a superjunction transistor device with an improved switching behavior.

The invention relates to a transistor device according to claim 1.

Examples are explained below with reference to the drawings. The drawings serve to illustrate certain principles, so that only aspects necessary for understanding these principles are illustrated. The drawings are not to scale. In the drawings the same reference characters denote like features.
Figure 1 illustrates one example of an electronic circuit that includes a transistor device as an electronic switch;
Figure 2 illustrates the dependency of an output capacitance of a superjunction transistor device on a drain-source voltage;
Figure 3 schematically illustrates a vertical cross sectional view of a superjunction transistor device that includes a plurality of transistor cells according to one example of the present invention;
Figur 4 illustrates a transistor cell according to another example;
Figures 5A-5D illustrate a horizontal cross sectional view and three vertical cross sectional views of a transistor device of the type illustrated in Figure 3;
Figure 6 illustrates a modification of the transistor device shown in Figure 3, wherein the transistor device includes isolation regions between body regions and compensation regions;
Figure 7 illustrates an isolation region according to another example;
Figure 8 illustrates an isolation region according to yet another example; and
Figure 9 illustrates a top view of a transistor device according to one example.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

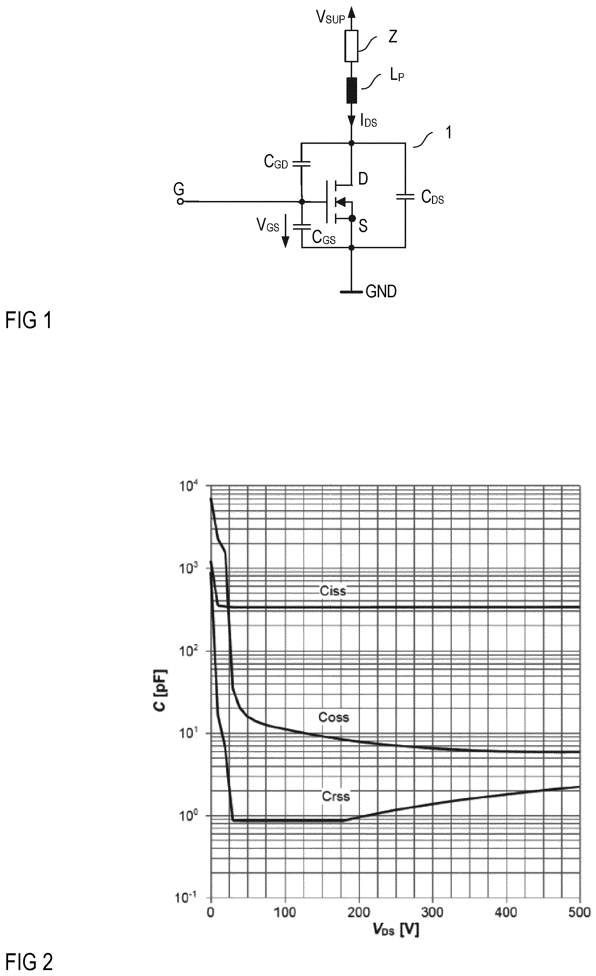

Figure 1 illustrates an electronic circuit that includes a transistor device 1 and a load Z. In this electronic circuit, the transistor 1 is used as an electronic switch for switching a load current I_{DS} through the load Z. The transistor device 1 includes a drive input G-S configured to receive a drive voltage V_{GS} and a load path D-S connected in series with the load Z. The series circuit including the load path D-S of the transistor device 1 and the load Z receives a supply voltage V_{SUP} from a voltage source (not shown). The load Z may include any kind of electric load or load circuit.

The transistor device 1 shown in Figure 1 is a MOSFET, more specifically, an n-type enhancement MOSFET. The load path of this type of transistor device is an internal current path between a drain node D and a source node S of the transistor device. Further, the drive input is formed by a gate node G and the source node S (as illustrated in Figure 1) or by an additional circuit node (not shown in Figure 1). In this type of transistor device, the drive voltage V_{GS} may also be referred to as gate-source voltage. However, implementing the transistor device 1 as an n-type enhancement MOSFET is only an example. Other examples of the transistor device 1 include an n-type depletion MOSFET, or a p-type enhancement or depletion MOSFET. According to one example, the transistor device is implemented as a superjunction transistor device.

The transistor device 1 switches on or off dependent on a voltage level of the drive voltage V_{GS} received at the drive input G-S. The transistor device 1 is in an on-state, in which it is capable of conducting a load current I_{DS} different from zero, when the drive voltage V_{GS} is higher than a threshold voltage of the transistor device 1. Further, the transistor device 1 is in an off-state, in which it is capable of blocking the load current I_{DS}, when the drive voltage V_{GS} is below the threshold voltage. In an n-type enhancement MOSFET, for example, the threshold voltage is a positive voltage of between 1V and 5V, for example. Dependent on the specific implementation of the transistor device 1, a voltage blocking capability of the transistor device 1 may range between 10V and several 100V, such as 600V, or even several kilovolts (kV), for example. The "voltage blocking capability" is the maximum voltage the transistor device 1 can withstand between its load nodes D, S.

The load current I_{DS} through the transistor device 1 changes, for example, when the switching state of the transistor device 1 changes. The changing load current I_{DS} may result in voltage spikes across inductances in the electronic circuit. These inductances may include (non-parasitic) inductances in the load Z or parasitic inductances, wherein parasitic inductances may include line inductances of any kind of connection lines included in the electronic circuit. Just for the purpose of illustration, inductor L_{P} in the electronic circuit shown in Figure 1 represents the parasitic inductances of connection lines between the transistor device 1, the load Z, and the power supply terminals where the supply voltage V_{SUP} is available. This, however, is only an example. Dependent on the specific implementation of the electronic circuit it may include further parasitic or non-parasitic inductances across which voltage spikes induced by a rapidly changing load current I_{DS} may occur. Basically, the higher the gradient of the load current I_{DS}, the higher a voltage level of voltage spikes that may occur when the transistor device 1 changes its switching state.

Referring to Figure 1, the transistor device includes a gate-source capacitance C_{GS}, which is a capacitance between the gate node G and the source node S, a gate-drain capacitances C_{GD}, which is a capacitance between the gate node G and the drain node D, and a drain-source capacitance C_{DS}, which is a capacitance between the drain node D and the source node S. These capacitances C_{GS}, C_{GD}, C_{DS} are internal capacitances and are represented by capacitors in the circuit diagram shown in Figure 1. The switching state of the transistor device 1 is dependent on a charging state of the gate-source capacitance C_{GS}, wherein the transistor device is in the on-state when the gate-source capacitance has been charged such that the gate-source voltage V_{GS}, which is the voltage across the gate-source capacitance C_{GS}, is higher than a threshold voltage.

The gradient of the load current I_{DS}, when the transistor device changes its switching state, is, inter alia, dependent on an output capacitance Coss of the transistor device, wherein the output capacitance Coss is given by the gate-drain capacitance C_{GD} plus the drain-source capacitance C_{DS} (C_{OSS}=C_{GD}+C_{DS}). More specifically, the gradient of the load current I_{DS} and also a gradient of the drain-source voltage V_{DS} are dependent on charging or discharging the output capacitance Coss when the transistor device changes its switching state.

In a superjunction transistor device, the output capacitance Coss and a feedback capacitance Crss (which is given by the gate-drain capacitance C_{GD}) are highly dependent on the drain-source voltage V_{DS}, which is the voltage between the drain node D and the source node S. This is illustrated in Figure 2, which illustrates the capacitance characteristics of a typical superjunction transistor device with a voltage blocking capability of 800V dependent on the drain-source voltage V_{DS}. As can be seen from Figure 2, for each of the output capacitance Coss and the feedback capacitance Crss there is a voltage range of the drain-source voltage V_{DS} in which the respective capacitance Coss, Crss steeply decreases as the drain-source voltage V_{DS} increases. The drain-source voltage V_{DS} increases when the transistor device 1 switches off.

When the transistor device switches off, for example, the load current (drain-source current) I_{DS} charges the output capacitance Coss. Referring to the above, there is a strong dependency of the output capacitance Coss on the drain-source voltage V_{DS} such that the output capacitance Coss significantly decreases to low capacitance values as the drain source voltage V_{DS} increases within a certain voltage range. This may have the effect that drain-source-voltage V_{DS} steeply increases over time and/or the load current I_{DS} steeply decreases over time when the transistor device 1 switches off.

Referring to the above, a high gradient (a steep increase) of the load current I_{DS} may cause high voltage spikes of voltages across (parasitic or non-parasitic) inductances in the electronic circuit. Such voltage spikes are undesirable in view of EMI (electromagnetic immission). Further, due to the capacitive coupling between the gate node G and the load path (the drain-source path D-S) via the gate-drain capacitance C_{GD} such voltage spikes may cause high voltages at the gate node G, which may even cause the transistor device to be damaged or destroyed. There is therefore a need for a transistor device, in particular a superjunction transistor device, with an improved switching behavior (a soft switching behavior), that is, with a relatively low time gradient of the load current I_{DS} and the drain-source-voltage V_{DS} when the transistor device switches on or off.

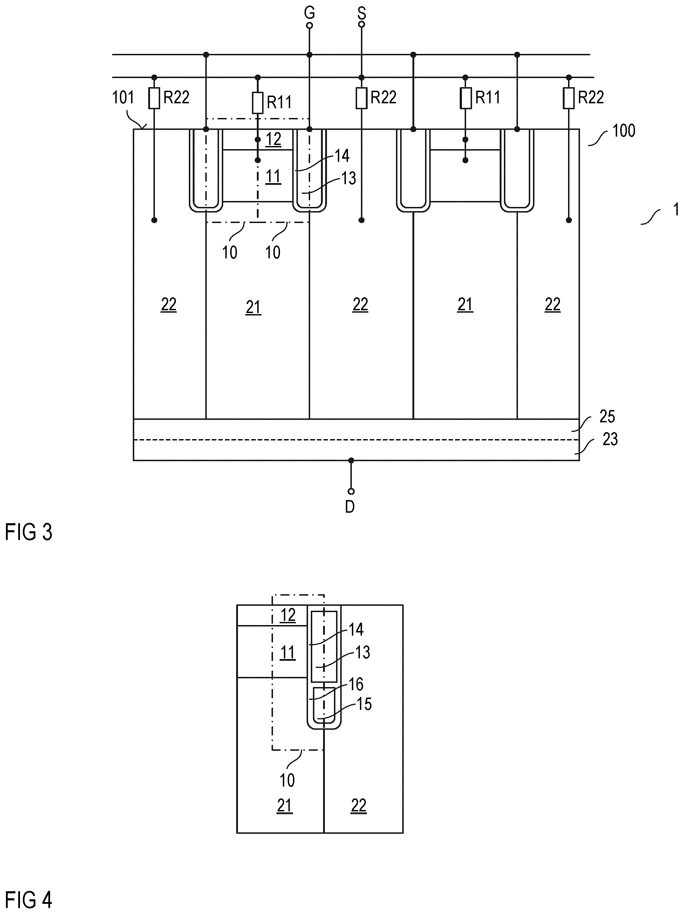

Figure 3 illustrates a vertical cross sectional view of a superjunction transistor device 1 with an improved switching behavior according to one example. More specifically, Figure 3 illustrates a vertical cross sectional view of a semiconductor body 100 in which active device regions of the transistor device 1 are integrated.

Referring to Figure 3, the transistor device includes a semiconductor body 100 and a plurality of drift regions 21 of a first doping type and a plurality of compensation regions 22 of a second doping type, wherein the drift regions 21 and the compensation regions 22 adjoin each other. The transistor device further includes a plurality of transistor cells each comprising a body region 11 adjoining a respective one of the plurality of drift regions 21, a source region 12 adjoining the body region 11, and a gate electrode 13. The gate electrode 13 of each transistor cell 10 is arranged adjacent the body region 11 of the respective transistor cell 10 and is dielectrically insulated from the body region 11 by a gate dielectric 14. The source regions 12 and the body regions 11 of the plurality of transistor cells 10 are connected to a source node S of the transistor device and the plurality of compensation regions 22 are connected to the source node S. The source node S and connections between the source regions 12, body regions 11, and compensation regions 22 and the source node S are only schematically illustrated in Figure 1. Examples for implementing these connections are explained herein further below.

Referring to Figure 3, the body regions 11 of the plurality of transistor cells 10 are separated from the plurality of compensation regions 22 in the semiconductor body 100. Thus, unlike a conventional superjunction transistor device, the compensation regions 22 are not connected to the source node S via the body regions 11. In this way, electrical resistances R22 between the compensation regions 22 and the source node S can be suitably adjusted in order to obtain a soft switching behavior without affecting the on-resistance R_{DS_ON}. This is explained in detail herein further below. The "on-resistance" is the electrical resistance between the drain node D and the source node S of the transistor device 1 in the on-state.

Referring to Figure 3, the gate electrodes 13 of the individual transistor cells 10 are connected to the gate node G, wherein the gate node G and connections between the gate node G and the gate electrodes 13 are only schematically illustrated in Figure 3. The gate-source capacitance C_{GS} (see Figure 1) of the transistor device is given by the capacitance between the gate node G and the source regions 12 and the body regions 11.

Referring to Figure 3, the transistor device further includes a drain region 23. The drain region 23 may adjoin the drift regions 21 and the compensation regions 22. Optionally, as illustrated in dashed lines in Figure 3, a buffer region 25 of the first doping type may be arranged between the drain region 23 and each of the drift regions 21 and the compensation regions 22. The drain region 23 forms the drain node D of the transistor device or is connected to the drain node D.

The transistor device shown in Figure 3 is a vertical transistor device, which is a transistor device in which the drain region 23 is spaced apart from the source regions 12 in a vertical direction of the semiconductor body 100. The "vertical direction" is a direction perpendicular to a first surface 101 of the semiconductor body 100, wherein the "first surface 101" is the surface below which the source regions 12 and the body regions 11 are arranged in the semiconductor body 100. However, implementing the transistor device as a vertical transistor device is only an example. The transistor device may also be implemented as a horizontal transistor device, which is a transistor device in which the drain region is spaced apart from the source regions in a lateral direction of the semiconductor body 100. The "lateral direction" is a direction parallel to the first surface 101.

Further, in the transistor device shown in Figure 3, the gate electrodes 13 are trench electrodes, which are electrodes arranged in trenches that extend from the first surface 101 into the semiconductor body 100. This, however, is only an example. The gate electrodes 13 may also be implemented as planar electrodes (not shown) that are arranged above the first surface 101.

In the example illustrated in Figure 3, the body regions 11 are separated from the compensation regions 22 by the gate electrodes 13 and the gate dielectrics 14. However, this is only one example of how the body regions 11 and the compensation regions 22 may be separated from each other. Further examples are explained herein further below.

According to one example, the semiconductor body 100 includes a monocrystalline semiconductor material. Examples of the monocrystalline semiconductor material include, but are not restricted to, silicon (Si), silicon carbide (SiC), gallium arsenide (GaAs), gallium nitride (GaN), or the like. According to one example, the semiconductor body 100 includes monocrystalline silicon and the individual active device regions are implemented such that a respective doping concentration is in a range as outlined in the following: drift region 11: between 1E15 cm⁻³ and 1E17 cm⁻³; compensation region 12: between 1E15 cm⁻³ and 1E17 cm⁻³; body region 13: between 1E17 cm⁻³ and 1E18 cm⁻³; source region 14: between 1E18 cm⁻³ and 1E21 cm⁻³; drain region 17: between 1E18 cm⁻³ and 1E21 cm⁻³; optional buffer region 18: between 1E14 cm⁻³ and 1E17 cm⁻³.

The gate electrodes 13 may include a metal or a highly doped polycrystalline semiconductor material such as polysilicon. The gate dielectrics 14 may include a semiconductor oxide such as silicon oxide.

The transistor device can be an n-type transistor device or a p-type transistor device. In an n-type transistor device, the source regions 12 and the drift regions 21 are n-type semiconductor regions and the body regions 11 and the compensation regions 22 are p-type semiconductor regions. In a p-type transistor device the doping types of the individual active device regions are complementary to the doping type of corresponding device regions in an n-type transistor device. Further, the transistor device can be implemented as a MOSFET (Metal Oxide Semiconductor Field-Effect Transistor) or as an IGBT (Insulated Gate Bipolar Transistor). In a MOSFET, the drain region 23 has the same doping type as the source regions 12. In an IGBT (Insulated Gate Bipolar Transistor), the drain region 23 has a doping type complementary to the doping type of the source regions 12.

Optionally, each transistor cell may further include a field electrode 15 that is adjacent the drift region 21 and dielectrically insulated from the drift region 21 by a field electrode dielectric 16. This is illustrated in Figure 4 that shows one transistor cell and sections of one drift region 21 and one compensation region 22. The field electrode 15 may be connected to the source node S or the gate node G. A connection between the field electrode 15 and one of the source node S and the gate node G, however, is not illustrated in Figure 4.

The transistor device can be operated in an on-state or an off-state. In the on-state, the gate electrode 13, by applying a suitable gate-source voltage V_{GS} between the gate node G and the source node S, of each transistor cell 10 is driven such that there is a conducting channel in the respective body region 11 between the source region 14 and the drift region 21 adjoining the body region 11. By virtue of this conducting channel a current can flow between the drain node D and the source node S when a drain-source voltage V_{DS} higher than zero is applied between the drain node D and the source node S. In the off-state, the gate electrodes 13 are driven such that the conducting channels in the body regions 11 between the source regions 12 and the drift regions 21 are interrupted. In the off-state, when applying a voltage between the drain node D and the source node S that reverse biases pn-junctions between the drift regions 21 on one side and the body regions 11 and compensations regions 22 on the other side, space charge regions (depletion regions) expand in the semiconductor body 100. In this operating state, a current flow through the transistor device is prevented.

In the transistor device shown in Figure 3, the drain-source capacitance C_{DS}, which is a significant portion of the output capacitance Coss, includes a first junction capacitance between the body regions 11 and the drift regions 21 and a second junction capacitance between the compensation regions 22 and the drift regions 21. When the transistor device switches from the on-state to the off-state dopant atoms in the body regions 11, the drift regions 21 and the compensation regions 22 are ionized so that charge carriers are "stored" in the junction capacitances, in particular, the second junction capacitance formed by the drift and compensation regions 21, 22. When the transistor device switches from the off-state to the on-state, these stored charge carriers are removed so that the transistor device can conduct a current. Charging and discharging the junction capacitances is associated with a current flow of the drain-source current I_{DS}.

In the transistor device according to Figure 3, charging and discharging the junction capacitances is dependent on resistances R22 between the compensation regions 22 and the source node S. Thus, the drain-source current I_{DS} and, in particular, the gradient of the drain-source current I_{DS} when the transistor device 1 switches off, can be adjusted by suitably adjusting these resistances R22. These resistances are referred to as first resistances R22 in the following. Basically, e.g. for the off-switching behavior, the higher the first resistances R22, the lower the gradient of the drain-source current I_{DS} before the drain-source current I_{DS} finally decreases to zero. Thus, by separating the body regions 11 from the compensation regions and by suitably adjusting the resistances R22 between the compensation regions 22 and the source node S an improved (soft) switching behavior is achieved.

In Figure 3, R11 denotes resistances between the source and body regions 12, 11 of the transistor cells 10 and the source node S. These resistances R11, which are referred to as second resistances in the following, affect the on-resistance of the transistor device 1, wherein the lower these second resistances R11, the lower the on-resistance.

In order to achieve a low on-resistance it may be desirable to implement the second resistors R11 as low as possible. Further, in order to achieve a soft switching behavior it is desirable to implement the first resistors R22 such that charging and discharging the second junction capacitance is slowed down as compared to a conventional device in which the compensation regions are coupled to the source node via the body regions.

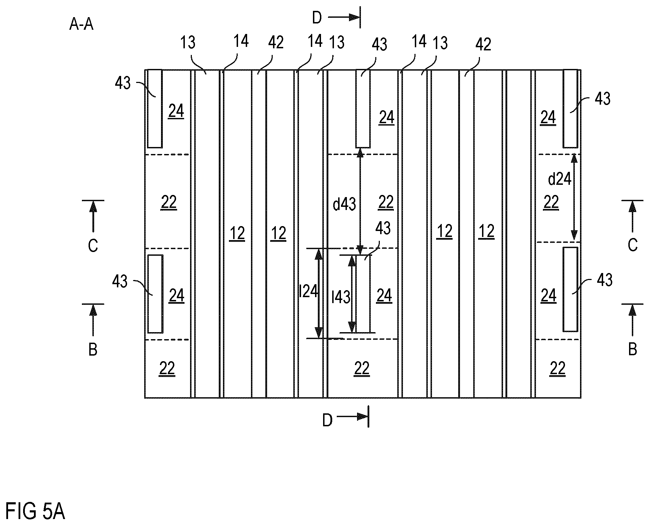

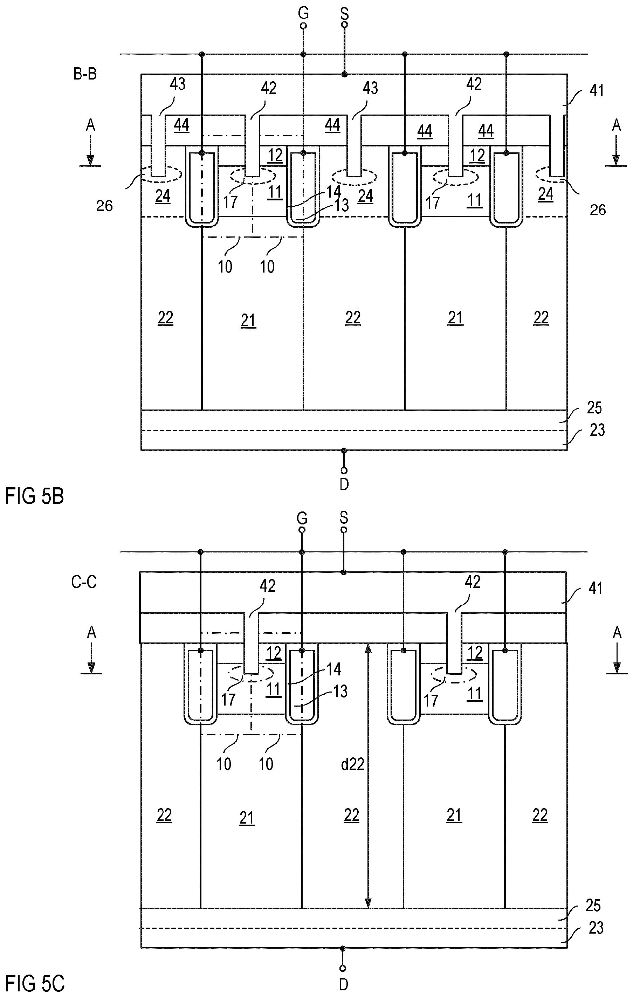

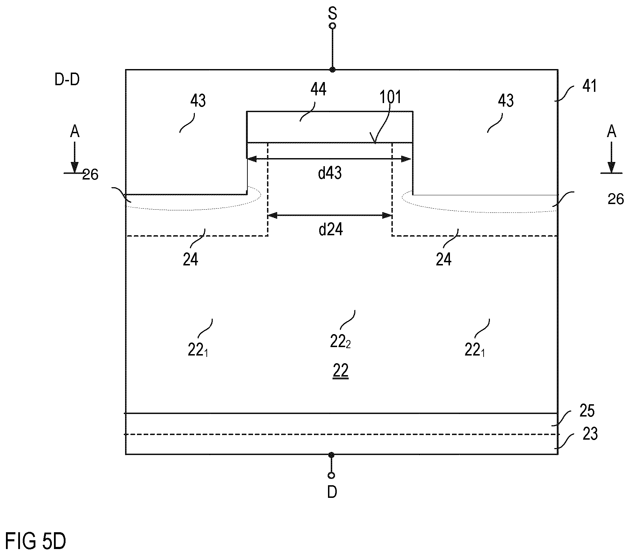

The first resistances R22 between the compensation regions 22 and the source node S may be adjusted in various ways. One example according the present invention for adjusting these resistances R22 is illustrated in Figures 5A to 5D. Figure 5A shows a horizontal cross sectional view of a transistor device of the type shown in Figure 3 in a horizontal section plane A-A that is essentially parallel to the first surface 101 of the semiconductor body 100 and cuts through the source regions 12 of the individual transistor cells 10; Figure 5B shows a vertical cross sectional view of the transistor device in a first vertical section plane B-B illustrated in Figure 5A; Figure 5C shows a vertical cross sectional view of the transistor device in a second vertical section plane C-C illustrated in Figure 5A; and Figure 5D shows a vertical cross sectional view of the transistor device in a third vertical section plane D-D illustrated in Figure 5A. Referring to Figure 5A, the compensation regions 22 are elongated semiconductor regions. Equivalently, the drift regions 21, which are out of view in Figure 5A and located below the source regions 12 and the body regions 11 (which are also out of view in Figure 5A), are elongated semiconductor regions that are essential parallel to the compensation regions 22. The gate electrodes 13 are elongated electrodes arranged between the source regions 12 and the body regions 11 on one side and the compensation regions 22 on the other side.

Referring to Figures 5B to 5D, the transistor device includes a source metallization 41 that is arranged above the first surface 101 on top of an insulation layer 44. The source metallization 41 forms the source node S of the transistor device or is connected to the source node S of the transistor device. The source metallization 41 is connected to the source regions 12 and the body regions 11 of the individual transistor cells 10 via first contact plugs 42, wherein these first contact plugs 42 extend from the source metallization 41 through the insulation layer 44 to the source and body regions 12, 11. Further, the source metallization 41 is connected to the compensation regions 22 via second contact plugs 43 that extend from the source metallization 41 through the insulation layer 44 to the first surface 101 of the semiconductor body 100 or into the semiconductor body 100.

The first contact plugs 42 are ohmically connected to the source and body regions 12, 11. That is, there is no rectifying junction between the first contact plugs 42 and the source and body regions 12, 11. In order to achieve an ohmic contact between the first contact plugs 42 and the body regions 11 first contact regions 17 of the same doping type as the body regions 11, but more highly doped than the body regions 11, may be arranged between the first contact plugs 42 and the body regions 11. According to one example, the doping concentration of the source regions 12 is high enough to provide for an ohmic contact between the source regions 12 and the first contact plugs 42, so that additional contact regions between the first contact plugs 42 and the source regions 12 may be not necessary.

The second contact plugs 43 are ohmically connected to the compensation regions 22. That is, there is no rectifying junction between the second contact plugs 43 and the compensation regions 22. For this, the transistor device may include highly doped second contact regions 26 that adjoin the second contact plugs 43 and that are arranged between the second contact plugs 43 and the compensation regions 22. The second contact regions 26 have the same doping type as the compensation regions 22 and a doping concentration that is high enough to provide for an ohmic contact between the second contact regions 26 and the second contact plugs 43.

Referring to Figure 5A, each of the compensation regions 22 is connected to the source metallization 41 through a plurality of second contact plugs 43, wherein these second contact plugs 43 are spaced apart from each other. In the example shown in Figure 5A, in which the compensation regions 22 are elongated regions, the second contact plugs 43 are spaced apart from each other in a longitudinal direction of the compensation regions 22. The "longitudinal direction" of a compensation region 22 is a direction perpendicular to a direction in which the compensation region 22 adjoins neighboring drift regions 21.

The respective first resistance R22 arranged between each compensation region 22 and the source metallization can be adjusted by adjusting a distance d43 between neighboring second contact plugs 43. In this context it should be noted that each of the first resistances R22 is not a lumped resistance, but may be considered to include a plurality of sub-resistances, wherein each of these sub- resistances connects a respective portion of the compensation region 22 and, therefore, a respective portion of the second junction capacitance to the source metallization 41. Between portions of the compensation regions 22 located below the second contact plugs 43 and the source metallization 41, for example, there is a lower sub-resistance than between portions of the compensation regions 22 not located below the second contact plugs 43 and the source metallization 41. This is explained with reference to Figure 5D.

Figure 5D shows a vertical cross sectional view of a compensation region 22 in a vertical section plane D-D that extends in the longitudinal direction of the compensation region 22 and cuts through the second contact plugs 43. When the transistor device switches off dopant atoms in the compensation region 22 are ionized. This ionization is associated with charging the second junction capacitance. Ionizing the dopant atoms in the compensation region 22 includes a charge carrier flow between the source metallization 41 and the compensation region 22. According to one example, the electrical resistance of the contact plugs 43 and the source metallization 41, which may include a metal or a highly doped polycrystalline semiconductor material, can be neglected as compared to the electrical resistance of the compensation region 22. In this case, the electrical resistance between certain portions of the compensation region 22 and the source metallization 41 is mainly dependent on a shortest distance between the respective portion of the compensation region 22 and the nearest second contact plug 43. Thus, between first portions 22₁ of the compensation region 22 that are located directly below a second contact plug 43 and the source metallization 41 there is a lower sub-resistance than between second portions 22₂ of the compensation region 22 that are not located directly below a second contact plug 43 and the source metallization 41. In order to reach the nearest second contact plug 43, charge carriers from the first portions 22₁ essentially have to travel in the vertical direction of the semiconductor body 100, and charge carriers from the second portions 22₂ essentially have to travel both in the vertical direction and the lateral direction. In this way, charging the second junction capacitance is slowed down. Thus, by suitably implementing the dimensions of the second portions 22₂ the rate of charging (and discharging) the second junction capacitance and, therefore, the gradient of the drain-source current I_{DS} can be limited.

According to one example according to the present invention, the second contact plugs 43 are implemented such that the distance d43 between neighboring second plugs 43 is dependent on a (maximum) vertical dimension d22 of the compensation region 22. According to one example according to the present invention, the distance d43 between neighboring second contact plugs 43 is selected from between 0.1 times and 10 times, in particular from between 0.5 times and 5 times the vertical dimension d22 of the compensation region 22. Basically, the larger the distance d43 between neighboring second plugs 43 the longer it takes to charge or discharge the second junction capacitance and the lower the gradient of the drain-source current I_{DS} and/or the drain-source voltage V_{DS}.

According to another example, the second contact plugs 43 are implemented such that the distance d43 between neighboring second plugs 43 is dependent on a (shortest) distance between the first surface 101 of the semiconductor body 100 and the drain region 23 or the buffer region 25. According to one example, the distance d43 between neighboring second contact plugs 43 is selected from between 0.1 times and 10 times, in particular from between 0.5 times and 5 times of this distance between the first surface 101 of the semiconductor body 100 and the drain region 23 or the buffer region 25.

According to another example, the second contact plugs 43 are implemented such that the distance d43 between neighboring second plugs 43 is between 5 micrometers and 100 micrometers, in particular between 10 micrometers and 50 micrometers.

Charging and discharging the second junction capacitance, however, is not only dependent on the distance between neighboring second contact plugs 43, but also on a dimension of the second contact plugs 43 in the direction in which the second contact plugs 43 are spaced apart from each other. According to one example, a length l43 of the second contact plugs 43 is between 0.001 times and 10 times the distance d43 between neighboring second contact plugs 43. According to another example, the length is between 200 nanometers and 50 micrometers (µm).

A width of the second contact plugs 42, which is a dimension in a direction perpendicular to the direction of the length l43, is between 0.01 times and 0.9 times the distance between neighboring gate trenches. According to one example, the width is between 200 nanometers and 1000 nanometers.

Optionally, each of the second contact plugs 43 and/or the optional second contact regions 26 adjoin a respective intermediate region 24 that has the same doping type as the compensation regions 22 and a doping concentration that is between the doping concentration of the compensation regions 22 and the contact regions 26. According to one example, the doping concentration of the intermediate regions 24 essentially equals the doping concentration of the body regions 11. According to another example, the doping concentration of the intermediate regions 24 is at least 10 times the doping concentration of the compensation regions 22. The intermediate regions 24 connect the compensation regions 22 to the second contact plugs 43.

According to one example according to the present invention, a plurality of intermediate regions 24 are embedded in each of the compensation regions 22, wherein each intermediate region 24 is arranged between the compensation region 22 and a respective second contact plug 43. According to one example according to the present invention, the intermediate regions 24 are spaced apart from each other. According to one example according to the present invention, a distance d24 between two neighboring intermediate regions 24 is selected: from between 0.1 times and 10 times, in particular from between 0.5 times and 5 times, of the vertical dimension d22 of the compensation region 22; from between 0.1 times and 10 times, in particular from between 0.5 times and 5 times, of the distance between the first surface 101 of the semiconductor body 100 and the drain region 23 or the buffer region 25; or from between 5 micrometers and 100 micrometers, in particular between 10 micrometers and 50 micrometers. A length l24 of the intermediate regions 24 is greater than the length l43 of the second contact plugs 43, for example. According to one example, the length of the intermediate regions 24 is between 1.05 times and 1.2 times the length of the second contact plugs 43.

In the following, A43 denotes a first overall cross sectional area of the second contact plugs 43 connected to one compensation region 22. Equivalently, A42 denotes the overall cross sectional area of the first contact plugs 42 connected to one or more body regions 11 adjoining the same drift region 21. According to one example, an average A42_{AVG} of the first cross sectional areas A42 is greater than an average A43_{AVG} of the second cross sectional areas A43. According to one example, the first average cross sectional area A42_{AVG} is at least 2 times, at least 5 times or at least 10 times the second average cross sectional area A43_{AVG}. According to another example, a total first cross sectional area A42_{TOT}, which is the sum of the first cross sectional areas A42, is greater than a second total cross sectional area A43_{TOT}, which is the sum of the second cross sectional areas A43. According to one example, the first total cross sectional area A42_{TOT} is at least 2 times, at least 5 times or at least 10 times the second total cross sectional area A43_{TOT}.

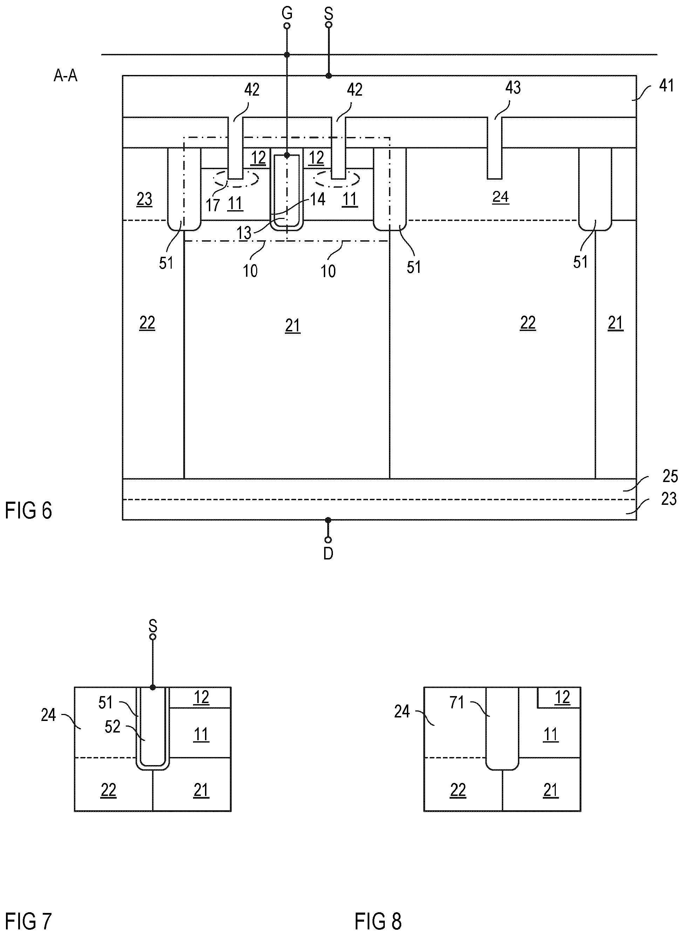

In the examples according to the present invention, illustrated in Figures 3 and 5A to 5C, the body regions 11 are separated from the compensation regions 22 by the gate electrodes 13 and the gate dielectrics 14. According to another example according to the present invention illustrated in Figure 6, isolation regions 51 are arranged between the body regions 11 and the compensation regions 22. Referring to Figure 6 these isolation regions 51 may include trenches that extend from the first surface 101 into the semiconductor body, wherein these trenches are filled with an insulator such as, for example, an insulating solid, an insulating gas, a vacuum, or a combination thereof (such as an insulating solid covering trench sidewalls and an insulating gas or a vacuum filling a residual trench).. In the vertical direction, these isolation regions 51 extend through the body regions 11 into the drift region 21.

In example shown in Figure 6, the gate electrodes 13 of two transistor cells 10 are formed by one trench electrode, wherein the source regions 12 and the body regions 11 of the two transistor cells 10 are separated from each other by the gate electrode 13 and the gate dielectric 14. The source and body regions 12, 11 of each transistor cell 10 are connected to the source metallization 41 via a respective first contact plug 42.

Figure 7 illustrates a modification of the isolation region shown in Figure 6. In this example, the isolation region includes an electrode 52 embedded in the insulating material 51. The electrode 52 may be connected to the source node S (as illustrated). Alternatively, the electrode 52 may be floating (not illustrated).

Figure 8 illustrates another example of an isolation region. In this example, the isolation region arranged between a compensation region 22 and a body region 11 includes a semiconductor region 71 of a doping type complementary to the doping type of the compensation region 22 and the body region 11 (and the same doping type as the source region 12). In this way, a junction isolation with two pn-junctions is formed between the compensation region 22 and the body region 11. The source region 12 is separated from the isolation region 71 by a semiconductor region of the same doping type as the body region 11 and may be separated from the isolation region 71 by a section of the body region 11.

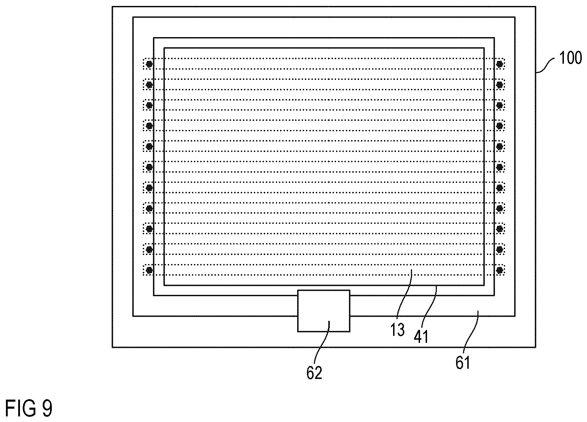

Referring to the above, the gate electrodes 13 of the individual transistor cells 10 are connected to a gate node G of the transistor device. According to one example, illustrated in Figure 9, the gate node G of the transistor device is formed by a gate pad 62 that is arranged above the first surface 101 of the semiconductor body and may be arranged on top of the insulation layer 44. A gate runner 61 is connected to the gate pad 62, surrounds the source metallization 41 and is connected to the gate electrodes 13 (which are only schematically illustrated by dotted lines in Figure 9). In this example, the gate electrodes 13 extend beyond the source metallization 41 in lateral directions of the semiconductor body 100, and the gate runner 61 is connected to those sections of the gate electrodes 13 extending beyond the source metallization 41. The gate runner 61 is connected to the gate electrodes 13 via contact plugs, wherein these contact plugs are only schematically illustrated by black dots in Figure 8.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the appended claims.

## Claims

1. A transistor device, comprising:
a semiconductor body (100);
a plurality of drift regions (21) of a first doping type;
a plurality of compensation regions (22) of a second doping type adjoining the drift regions (21) and ohmically connected to a source node (S);
a plurality of transistor cells (10) each comprising a body region (11) adjoining a respective one of the plurality of drift regions (21), a source region (12) adjoining the body region (11) and connected to the source node (S), and a gate electrode (13) adjacent the body region (11) and dielectrically insulated from the body region (11) by a gate dielectric;
a source metallization (41) arranged above a first surface (101) of the semiconductor body (100); and
a drain region (23) coupled to the plurality of drift regions (21) and spaced apart from the source region (12) of each transistor cell in a vertical direction of the semiconductor body (100),
wherein the body regions (11) of the plurality of transistor cells (10) are separated from the plurality of compensation regions (22) in the semiconductor body (100),
wherein the source metallization is connected to the source node (S) or forms the source node (S), is connected to each of the source regions (12) of the plurality of transistor cells (10) through at least one first contact plug (42), and is connected to each of the plurality of compensation regions (22) through a plurality of second contact plugs (43),
wherein the compensation regions (22) have a longitudinal direction, which is a direction perpendicular to a direction in which each of the compensation regions (22) adjoins a neighboring drift region (21),
wherein the second contact plugs (43) are spaced apart from each other in the longitudinal direction of the compensation regions (22),
wherein each of the compensation regions (22) has a dimension (d22) in a vertical direction of the semiconductor body (100), and
wherein a distance between two neighboring second contact plugs (43) of the plurality of second contact plugs (43) is between 0.1 times and 10 times the vertical dimension (d22) of the respective compensation region (22).

2. The transistor device of claim 1,
wherein the gate electrodes (13) and the gate dielectrics of the plurality of transistor cells are arranged in gate trenches of the semiconductor body (100),
and wherein the body regions (11) of the plurality of transistor cells (10) are separated from the plurality of compensation regions (22) by the gate trenches.

3. The transistor device of claim 1,
wherein the body regions (11) of the plurality of transistor cells (10) are separated from the plurality of compensation regions (22) by trenches in the semiconductor body that have at least their surfaces covered with an insulator (51).

4. The transistor device of claim 1,
wherein the body regions (11) of the plurality of transistor cells (10) are separated from the plurality of compensation regions (22) by semiconductor regions (71) of a doping type complementary to the doping type of the body regions (11) and the compensation regions (22).

5. The transistor device of claim 1,
wherein a distance between two neighboring second contact plugs (43) of the plurality of second contact plugs (43) is greater than 10 micrometers.

6. The transistor device of any one of the preceding claims, further comprising:
a plurality of intermediate regions (24) of the second doping type,
wherein each of the plurality of intermediate regions (24) is arranged between a respective one of the plurality of second contact plugs (43) and the respective compensation region (22),
wherein a doping concentration of each of the plurality of intermediate regions (24) is higher than a doping concentration of the respective compensation region (22), and
wherein the plurality of intermediate regions (24) are spaced apart from each other.

7. The transistor device of claim 6,
wherein each of the compensation regions (22) has a dimension (d22) in a vertical direction of the semiconductor body (100), and
wherein a distance between two neighboring intermediate regions (24) of the plurality of intermediate regions (24) is between 0.1 times and 10 times the vertical dimension (d22) of the respective compensation region (22).

8. The transistor device of any one of the preceding claims, wherein an overall cross sectional area of the first contact plugs (42) is greater than an overall cross sectional area of the second contact plugs (43).

9. The transistor device of any one of the preceding claims,
wherein the plurality of compensation regions (22) and the body regions (11) of the plurality of transistor cells (10) are elongated in a first lateral direction of the semiconductor body (100) and essentially parallel to each other.

## Patentansprüche

1. Transistorbauelement, das aufweist:
einen Halbleiterkörper (100);
mehrere Driftgebiete (21) eines ersten Dotierungstyps;
mehrere Kompensationsgebiete (22) eines zweiten Dotierungstyps, die an die Driftgebiete (21) angrenzen und ohmsch an einen Sourceknoten (S) angeschlossen sind;
mehrere Transistorzellen (10), die jeweils ein Bodygebiet (11), das an ein jeweiliges der mehreren Driftgebiete (21) angrenzt, ein Sourcegebiet (12), das an das Bodygebiet (11) angrenzt und an den Sourceknoten (S) angeschlossen ist, und eine Gateelektrode (13) , die an das Bodygebiet (11) angrenzt und von dem Bodygebiet (11) durch ein Gatedielektrikum dielektrisch isoliert ist, aufweisen;
eine Sourcemetallisierung (41), die über einer ersten Oberfläche (101) des Halbleiterkörpers (100) angeordnet ist; und
ein Draingebiet (23), das an die mehreren Driftgebiete (21) gekoppelt ist und von dem Sourcegebiet (12) jeder Transistorzelle in einer vertikalen Richtung des Halbleiterkörpers (100) beabstandet ist,
wobei die Bodygebiete (11) der mehreren Transistorzellen (10) von den mehreren Kompensationsgebieten (22) in dem Halbleiterkörper (100) getrennt sind, wobei die Sourcemetallisierung an den Sourceknoten (S) angeschlossen ist oder den Sourceknoten (S) bildet, an jedes der Sourcegebiete (12) der mehreren Transistorzellen (10) durch mindestens einen ersten Kontaktstopfen (42) angeschlossen ist und an jedes der mehreren Kompensationsgebiete (22) durch mehrere zweite Kontaktstopfen (43) angeschlossen ist,
wobei die Kompensationsgebiete (22) eine Längsrichtung haben, welches eine Richtung senkrecht zu einer Richtung ist, in der jedes der Kompensationsgebiete (22) an ein benachbartes Driftgebiet (21) angrenzt,
wobei die zweiten Kontaktstopfen (43) in der Längsrichtung der Kompensationsgebiete (22) voneinander beabstandet sind,
wobei jedes der Kompensationsgebiete (22) eine Abmessung (d22) in einer vertikalen Richtung des Halbleiterkörpers (100) hat, und
wobei ein Abstand zwischen zwei benachbarten zweiten Kontaktstopfen (43) der mehreren zweiten Kontaktstopfen (43) zwischen dem 0,1-fachen und dem 10-fachen der vertikalen Abmessung (d22) des jeweiligen Kompensationsgebiets (22) beträgt.

2. Transistorbauelement nach Anspruch 1,
wobei die Gateelektroden (13) und die Gatedielektrika der mehreren Transistorzellen in Gategräben des Halbleiterkörpers (100) angeordnet sind,
und wobei die Bodygebiete (11) der mehreren Transistorzellen (10) von den mehreren Kompensationsgebieten (22) durch die Gategräben getrennt sind.

3. Transistorbauelement nach Anspruch 1,
wobei die Bodygebiete (11) der mehreren Transistorzellen (10) von den mehreren Kompensationsgebieten (22) durch Gräben in dem Halbleiterkörper getrennt sind, von denen zumindest ihre Oberflächen mit einem Isolator (51) bedeckt sind.

4. Transistorbauelement nach Anspruch 1,
wobei die Bodygebiete (11) der mehreren Transistorzellen (10) von den mehreren Kompensationsgebieten (22) durch Halbleitergebiete (71) eines Dotierungstyps getrennt sind, der zu dem Dotierungstyp der Bodygebiete (11) und der Kompensationsgebiete (22) komplementär ist.

5. Transistorbauelement nach Anspruch 1,
wobei ein Abstand zwischen zwei benachbarten zweiten Kontaktstopfen (43) der mehreren zweiten Kontaktstopfen (43) größer als 10 Mikrometer ist.

6. Transistorbauelement nach einem der vorhergehenden Ansprüche, das ferner aufweist:
mehrere Zwischengebiete (24) des zweiten Dotierungstyps,
wobei jedes der mehreren Zwischengebiete (24) zwischen einem jeweiligen der mehreren zweiten Kontaktstopfen (43) und dem jeweiligen Kompensationsgebiet (22) angeordnet ist,
wobei eine Dotierungskonzentration jedes der mehreren Zwischengebiete (24) höher ist als eine Dotierungskonzentration des jeweiligen Kompensationsgebiets (22), und
wobei die mehreren Zwischengebiete (24) voneinander beabstandet sind.

7. Transistorbauelement nach Anspruch 6,
wobei jedes der Kompensationsgebiete (22) eine Abmessung (d22) in einer vertikalen Richtung des Halbleiterkörpers (100) hat, und
wobei ein Abstand zwischen zwei benachbarten Zwischengebieten (24) der mehreren Zwischengebiete (24) zwischen dem 0,1-fachen und dem 10-fachen der vertikalen Abmessung (d22) des jeweiligen Kompensationsgebiets (22) beträgt.

8. Transistorbauelement nach einem der vorhergehenden Ansprüche, wobei eine Gesamtquerschnittsfläche der ersten Kontaktstopfen (42) größer ist als eine Gesamtquerschnittsfläche der zweiten Kontaktstopfen (43).

9. Transistorbauelement nach einem der vorhergehenden Ansprüche,
wobei die mehreren Kompensationsgebiete (22) und die Bodygebiete (11) der mehreren Transistorzellen (10) in einer ersten lateralen Richtung des Halbleiterkörpers (100) langgestreckt und im Wesentlichen parallel zueinander sind.

## Revendications

1. Un dispositif de transistor, comprenant :
un corps (100) à semiconducteur ;
une pluralité de régions (21) de migration d'un premier type de dopage ;
une pluralité de régions (22) de compensation d'un deuxième type de dopage adjointes aux régions (21) de migration et connectées ohmiquement à un nœud (S) de source ;
une pluralité de cellules (10) de transistor comprenant chacune une région (11) de corps adjointe à l'une respective de la pluralité de régions (21) de migration, une région (12) de source adjointe à la région (11) de corps et connectée au nœud (S) de source, et une électrode (13) de grille adjointe à la région (11) de corps et isolée diélectriquement de la région (11) de corps par un diélectrique de grille ;
une métallisation (41) de source disposée au-dessus d'une première surface (101) du corps (100) à semiconducteur ; et
une région (23) de drain couplée à la pluralité de régions (21) de migration et à distance de la région (12) de source de chaque cellule de transistor dans une direction verticale du corps (100) à semiconducteur,
dans lequel les régions (11) de corps de la pluralité de cellules (10) de transistor sont séparées de la pluralité de régions (22) de compensation dans le corps (100) à semiconducteur,
dans lequel la métallisation de source est connectée au nœud (S) de source ou forme le nœud (S) de source, est connectée à chacune des régions (12) de source de la pluralité de cellules (10) de transistor par au moins une première fiche (42) de contact, et est connectée à chacune de la pluralité des régions (22) de compensation par une pluralité de deuxièmes fiches (43) de contact,
dans lequel les régions (22) de compensation ont une direction longitudinale, qui est une direction perpendiculaire à une direction, dans laquelle chacune des régions (22) de compensation est adjointe à une région (21) voisine de migration,
dans lequel les deuxièmes fiches (43) de contact sont à distance les unes des autres dans la direction longitudinale des régions (22) de compensation,
dans lequel chacune des régions (22) de compensation a une dimension (d22) dans une direction verticale du corps (100) à semiconducteur, et
dans lequel une distance entre deux deuxièmes fiches (43) de contact voisines de la pluralité de deuxièmes fiches (43) de contact est comprise entre 0,1 fois et 10 fois la dimension (d22) verticale de la région (22) respective de compensation.

2. Le dispositif de transistor de la revendication 1,
dans lequel les électrodes (13) de grille et les diélectriques de grille de la pluralité de cellules de transistor sont disposés dans des tranchées de grille du corps (100) à semiconducteur,
et dans lequel les régions (11) de corps de la pluralité de cellules (10) de transistor sont séparées de la pluralité de régions (22) de compensation par les tranchées de grille.

3. Le dispositif de transistor de la revendication 1,
dans lequel les régions (11) de corps de la pluralité de cellules (10) de transistor sont séparées de la pluralité de régions (22) de compensation par des tranchées dans le corps à semiconducteur, qui ont au moins leurs surfaces recouvertes d'un isolant (51).

4. Le dispositif de transistor de la revendication 1,
dans lequel les régions (11) de corps de la pluralité de cellules (10) de transistor sont séparées de la pluralité de régions (22) de compensation par des régions (71) à semiconducteur d'un type de dopage complémentaire du type de dopage des régions (11) du corps et des régions (22) de compensation.

5. Le dispositif de transistor de la revendication 1,
dans lequel une distance entre deux deuxièmes fiches (43) de contact voisines de la pluralité de deuxièmes fiches (43) de contact est plus grande que 10 microns.

6. Le dispositif de transistor de l'une quelconque des revendications précédentes, comprenant en outre :
une pluralité de régions (24) intermédiaires du deuxième type de dopage,
dans lequel chacune de la pluralité de régions (24) intermédiaires est disposée entre l'une respective de la pluralité de deuxièmes fiches (43) de contact et la région (22) respective de compensation,
dans lequel une concentration de dopage de chacune de la pluralité de régions (24) intermédiaires est plus grande qu'une concentration de dopage de la région (22) respective de compensation, et
dans lequel la pluralité de régions (24) intermédiaires sont à distance les unes des autres.

7. Le dispositif de transistor de la revendication 6,
dans lequel chacune des régions (22) de compensation a une dimension (d22) dans une direction verticale du corps (100) à semiconducteur, et
dans lequel une distance entre deux régions (24) intermédiaires voisines de la pluralité de régions (24) intermédiaires est comprise entre 0,1 fois et 10 fois la dimension (d22) verticale de la région (22) respective de compensation.

8. Le dispositif de transistor de l'une quelconque des revendications précédentes,
dans lequel une surface de section transversale d'ensemble des premières fiches (42) de contact est plus grande qu'une surface de section transversale d'ensemble des deuxièmes fiches (43) de contact.

9. Le dispositif de transistor de l'une quelconque des revendications précédentes,
dans lequel la pluralité de régions (22) de compensation et les régions (11) de corps de la pluralité de cellules (10) de transistor sont allongées dans une première direction latérale du corps (100) à semiconducteur et sensiblement parallèles les unes aux autres.
